# EUROPÄISCHE PATENTSCHRIFT

(11) **EP 2 474 004 B1**
(45) Veröffentlichungstag und Bekanntmachung des Hinweises auf die Patenterteilung: **25.02.2015**
(21) Anmeldenummer: 10747636.8
(22) Anmeldetag: 01.09.2010
(51) Int. Cl.: H01B 1/02, H01B 1/22, H01L 21/28, H01L 21/288, H01L 31/0224

(54) **ZUSAMMENSETZUNG ZUM DRUCKEN VON ELEKTRODEN**
COMPOSITION FOR PRINTING ELECTRODES
COMPOSITION POUR IMPRIMER DES ÉLECTRODES

(30) Priorität: 04.09.2009 EP 09169548
(43) Veröffentlichungstag der Anmeldung: 11.07.2012
(73) Patentinhaber: BASF SE, 67056 Ludwigshafen (DE)
(72) Erfinder: KLEINE JÄGER, Frank, 67098 Bad Dürkheim (DE); KACZUN, Jürgen, 67157 Wachenheim (DE); HERMES, Stephan, 67098 Bad Dürkheim (DE)
(86) Internationale Anmeldenummer: PCT/EP2010/062775
(87) Internationale Veröffentlichungsnummer: WO 2011/026852

(56) Entgegenhaltungen:
- EP-A1- 1 887 106
- WO-A1-2007/089273
- WO-A2-2006/132766
- BERGSTROM D.: 'DOCTORAL Thesis: The Absorption of Laser Light by Rough Metal Surfaces', [Online] 01 Februar 2008, XP055124531 Gefunden im Internet: <URL:http://epubl.ltu.se/1402-1544/2008/08/ LTU-DT-0808-SE.pdf> [gefunden am 2014-06-20]

## Beschreibung

Die Erfindung betrifft eine Zusammensetzung zum Drucken von Elektroden auf einem Substrat, die elektrisch leitfähige Partikel, Glasfritte und Lösungsmittel enthält.

Zusammensetzungen, die elektrisch leitfähige Partikel und Glasfritte enthalten, die in einem Lösungsmittel dispergiert sind, werden insbesondere eingesetzt, um Elektroden auf Halbleitersubstrate zu drucken. Einsatz finden derartig bedruckte Halbleitersubstrate zum Beispiel als Solarzellen.

Zur Herstellung der Elektroden wird die Zusammensetzung mit einem üblichen Druckverfahren auf das Substrat aufgebracht. Als Druckverfahren eignen sich zum Beispiel Tintenstrahldruck oder Laserdruck.

Als elektrisch leitfähige Partikel enthält die Zusammensetzung im Allgemeinen Silberpartikel. Diese können plättchenförmig oder kugelförmig sein. Auch Mischungen von plättchenförmigen und kugelförmigen Silberpartikeln sind bekannt. Zur Einstellung der für den Druck notwendigen Viskosität enthält die Zusammensetzung ein Lösungsmittel. Üblicherweise werden organische Lösungsmittel eingesetzt. Dies hat jedoch den Nachteil, dass bei der Weiterverarbeitung nach dem Druck das Lösungsmittel aus der Zusammensetzung entweicht und so in die Umgebung gelangt.

Damit die Zusammensetzung nicht verläuft, ist üblicherweise auch ein Polymermaterial enthalten, mit dem die Zusammensetzung zunächst an das Halbleitermaterial angebunden wird. Nach dem Aufdrucken wird die Zusammensetzung im Allgemeinen gebrannt. Beim Brennen zersetzt sich das Polymermaterial und wird aus den Leiterbahnen entfernt. Die in der Zusammensetzung enthaltene Glasfritte schmilzt und bindet die aufgedruckten, die elektrisch leitfähigen Partikel enthaltenden Leiterbahnen an das Substrat an.

Eine Zusammensetzung in Pastenform, die zur Herstellung einer lichtempfangenden Oberflächenelektrode einer Solarzelle eingesetzt werden kann, ist zum Beispiel in WO 2007/089273 beschrieben. Die Paste enthält Silberpartikel mit einer spezifischen Oberfläche von 0,2 bis 0,6 m²/g, Glasfritte, Harzbindemittel und Verdünnungsmittel. Das eingesetzte Verdünnungsmittel ist dabei ein organisches Lösungsmittel.

Eine Zusammensetzung, die Silberpulver mit zwei unterschiedlichen mittleren Durchmessern enthält, ist in EP-A 1 775 759 beschrieben. Neben dem Silberpulver enthält die Zusammensetzung ebenfalls Glasfritte und einen organischen Träger. Der Anteil an Silber im Elektrodenmaterial beträgt 75 bis 95 Gew.-%.

Eine Paste zum Herstellen von Elektroden aus Solarzellen, die 85 bis 99 Gew.-% einer leitfähigen Metallkomponente und 1 bis 15 Gew.-% einer Glaskomponente sowie einen organischen Anteil enthält, ist in WO 2006/132766 beschrieben.

Nachteil dieser bekannten Zusammensetzung ist jedoch jeweils, dass beim Trocknen nach dem Aufbringen der Zusammensetzung bzw. beim Brennen die darin enthaltenen organischen Substanzen freigesetzt werden.

Daher ergibt sich die Aufgabe der vorliegenden Erfindung, eine Zusammensetzung zum Drucken von Elektroden bereitzustellen, bei der beim Trocknen und Brennen weniger organisches Material an die Umgebung freigesetzt wird.

Gelöst wird die Aufgabe durch eine Zusammensetzung zum Drucken von Elektroden auf einem Substrat, die 30 bis 90 Gew.-% elektrisch leitfähige Partikel, 0 bis 7 Gew.-% Glasfritte, 0,1 bis 5 Gew.-% mindestens eines Absorptionsmittels für Laserstrahlung, 0 bis 8 Gew.-% mindestens eines Matrixmaterials, 0 bis 8 Gew.-% mindestens einer metallorganischen Verbindung, 3 bis 50 Gew.-% Wasser als Lösungsmittel, 0 bis 65 Gew.-% mindestens eines Retentionsmittels und 0 bis 5 Gew.-% mindestens eines Additivs, jeweils bezogen auf die Gesamtmasse der Zusammensetzung, enthält.

Die erfindungsgemäße Zusammensetzung eignet sich insbesondere zum Drucken von Elektroden mit einem Laserdruckverfahren.

Durch den Einsatz von Wasser als Lösungsmittel wird der Anteil an organischen Substanzen, die beim Trocknen und Brennen der Zusammensetzung zur Herstellung der Elektroden an die Umgebung abgegeben werden, reduziert. Hierdurch lässt sich die Umweltbelastung bei der Herstellung der Solarzellen reduzieren.

In der Zusammensetzung enthaltene, elektrisch leitfähige Partikel können Partikel beliebiger Geometrie aus einem beliebigen elektrisch leitfähigen Material sein. Vorzugsweise enthalten elektrisch leitfähige Partikel, die in der Zusammensetzung enthalten sind, Silber, Gold, Aluminium, Platin, Palladium, Zinn, Nickel, Cadmium, Gallium, Indium, Kupfer, Zink, Eisen, Bismuth, Cobalt, Mangan, Chrom, Vanadium, Titan oder Mischungen oder Legierungen daraus.

Die mittlere Partikelgröße der eingesetzten Partikel liegt vorzugsweise im Bereich von 3 nm bis 100 µm. Mehr bevorzugt liegt die mittlere Partikelgröße im Bereich von 100 nm bis 50 µm und insbesondere im Bereich von 500 nm bis 10 µm. Die eingesetzten Partikel können dabei jede beliebige, dem Fachmann bekannte Form aufweisen. So können die Partikel zum Beispiel plättchenförmig oder kugelförmig sein. Unter kugelförmig sind dabei auch Partikel zu verstehen, deren reale Form von der idealen Kugelform abweicht. So können kugelförmige Partikel zum Beispiel herstellungsbedingt auch eine tropfenförmige Gestalt aufweisen oder abgeflacht sein. Geeignete Partikel, die zur Herstellung der Zusammensetzung eingesetzt werden können, sind dem Fachmann bekannt und im Handel erhältlich. Insbesondere bevorzugt werden sphärische Silberpartikel eingesetzt. Vorteil der sphärischen Partikel ist deren gegenüber plättchenförmigen Partikeln verbessertes rheologisches Verhalten. So weist eine Zusammensetzung, die.sphärische Partikel enthält, eine niedrigere Viskosität auf als eine Zusammensetzung mit plättchenförmigen Partikeln. Zudem weist eine Zusammensetzung, die sphärische Partikel enthält, eine starke Viskositätserniedrigung bei Scherung auf. Hierdurch lassen sich auch hohe Füllgrade von bis zu ungefähr 90% realisieren, bei denen die Zusammensetzung weiterhin druckbar verbleibt.

Sollten zwei oder mehr unterschiedliche Sorten elektrisch leitfähiger Partikel eingesetzt werden, so kann dies durch Mischung der Sorten erfolgen. Die Partikel der unterschiedlichen Sorten können sich dabei im Material, in der Form und/oder in der Größe unterscheiden.

Der Anteil an elektrisch leitfähigen Partikeln in der Zusammensetzung liegt im Bereich von 50 bis 90 Gew.-%. Bevorzugt liegt der Anteil im Bereich von 70 bis 87 Gew.-% und insbesondere im Bereich von 75 bis 85 Gew.-%.

Um eine druckbare Dispersion zu erhalten, enthält die Zusammensetzung Lösungsmittel. Erfindungsgemäß wird als Lösungsmittel Wasser eingesetzt, das in der Zusammensetzung mit einem Anteil von 3 bis 20 Gew.-% enthalten ist. Bevorzugt liegt der Anteil an Wasser in der Zusammensetzung im Bereich von 5 bis 15 Gew.-% und insbesondere im Bereich von 6 bis 12 Gew.-%.

Da Wasser im Allgemeinen relativ schnell verdunstet, ist die Zugabe eines Retentionsmittels, einem so genannten Verzögerer, notwendig, um die Verdunstung zu verlangsamen. Das Retentionsmittel liegt in der Zusammensetzung mit einem Anteil von 0 bis 65 Gew.-%, bevorzugt mit einem Anteil von 0,5 bis 10 Gew.-% und insbesondere mit einem Anteil im Bereich von 0,8 bis 4 Gew.-% vor.

Als Retentionsmittel eignen sich polare, wasserbindende Lösungsmittel. Geeignete polare, wasserbindende Lösungsmittel sind zum Beispiel Glyzerin, Glykole, beispielsweise Ethylenglykol, Propylenglykol, Polyglykole wie Diethylenglykole, Polyethylenglykole, (beispielsweise PEG200), Polypropylenglykol, Alkanolamine, beispielsweise Methyldiethanolamin, Ethyldiethanolamin, n-Methylpyrrolidon, Polyethylenimine, Polyvinylamin, Polyvinylformamid oder Mischungen daraus. Besonders bevorzugt als Retentionsmittel sind Glyzerin und Polyethylenglykole. Diese weisen eine hohe Oberflächenspannung auf, wodurch ein Verlaufen der Zusammensetzung auf der Oberfläche des zu bedruckenden Substrates verringert wird. Hierdurch sind klarere Strukturen druckbar.

Damit die Zusammensetzung vor dem eigentlichen Brennen des Wafers nicht verläuft, sondern am Wafer haftet, ist weiterhin ein Matrixmaterial enthalten.

Als Matrixmaterial werden vorzugsweise wasserlösliche bzw. wasserdispergierbare Polymere oder Polymergemische eingesetzt.

Bevorzugt sind wasserlösliche bzw. wasserdispergierbare Polymere oder Polymergemische, die niedrigviskose Lösungen in Wasser bilden. Hierdurch ist ein hoher Füllgrad an elektrisch leitfähigen Partikeln bei geringer Viskosität möglich. Weiterhin sollten die eingesetzten Polymere eine gute Haftung zur zu bedruckenden Substratoberfläche, beispielsweise bei der Herstellung von Solarzellen der Oberfläche des eingesetzten Solar-Wafers, aufweisen. Auch sollten die Polymere zu einer ausreichenden Integrität der gedruckten Leiterbahnen führen.

Geeignete Polymere, die als Matrixmaterial verwendet werden können, sind zum Beispiel Acrylatdispersionen und Acrylat-Copolymere, beispielsweise Styrol-Acrylate, alkalilösliche Acrylatharze und dessen Copolymere, Maleinsäureanhydridcopolymere, beispielsweise Styrol-Maleinsäuredispersionen, Alkydharzdispersionen, Styrolbutadiendispersionen, Cellulosederivate, insbesondere Hydroxyalkylcellulosen, Carboxyalkylcellulosen, Polyesterdispersionen, Polyvinylalkohole, insbesondere teil- oder vollverseifte Polyvinylalkohole, hydrolisierte Vinylacetatcopolymere, beispielsweise gepfropfte Polyethylenglykol-Vinylacetat-Copolymere, Polyvinylpyrrolidon und Vinylpyrrolidon-Copolymere, Polyethylenimine, Polyvinylamin, Polyvinylformamid, hyperverzweigte Polycarbonate, Polyglykole, Polyurethandispersionen, Proteine, beispielsweise Casein. Auch können Mischungen zweier oder mehrerer Polymere das Matrixmaterial bilden.

Um eine gute Anhaftung der Zusammensetzung an das als Substrat eingesetzte Halbleitermaterial bei der Herstellung von Solarzellen zu erhalten, ist in der Zusammensetzung eine Glasfritte mit einem Anteil im Bereich von 0 bis 7 Gew.-% enthalten. Bevorzugt liegt der Anteil an Glasfritte im Bereich von 1,5 bis 4 Gew.-% und insbesondere im Bereich von 2 bis 3,5 Gew.-%.

Eingesetzt werden vorzugsweise im Wesentlichen bleifreie Glasfritten. Derartige Glasfritten sind zum Beispiel Bismutoxid-basierte Gläser. Für die Zusammensetzung geeignete Glasfritten enthalten insbesondere Bismutoxid, Siliciumoxid und/oder Telluroxid. Der Anteil an Telluroxid liegt vorzugsweise im Bereich von 0,01 bis 10 Gew.-%. Der Anteil an Bismutoxid liegt vorzugsweise im Bereich von 40 bis 95 Gew.-%. Mehr bevorzugt liegt der Anteil an Bismutoxid im Bereich von 50 bis 80 Gew.-% und insbesondere im Bereich von 60 bis 75 Gew.-%. Der Anteil an Siliciumoxid liegt vorzugsweise im Bereich von 0 bis 30 Gew.-%, insbesondere im Bereich von 1 bis 4 Gew.-%, jeweils bezogen auf die Masse der Glasfritte.

Neben Bismutoxid, Siliciumoxid und Telluroxid kann die Glasfritte zusätzlich Boroxid enthalten. Der Anteil an Boroxid liegt dabei vorzugsweise im Bereich von 0,1 bis 10 Gew.-%, insbesondere im Bereich von 0,5 bis 8 Gew.-% und in einer besonders bevorzugten Ausführungsform im Bereich von 1 bis 4 Gew.-%.

Zusätzlich zu den genannten Oxiden kann die Glasfritte Zinkoxid und/oder Aluminiumoxid enthalten. Der Anteil an Zinkoxid liegt dabei im Bereich von 0 bis 15 Gew.-% und der Anteil an Aluminiumoxid im Bereich von 0 bis 3 Gew.-%.

Weitere Metalloxide, die in der Glasfritte enthalten sein können, sind zum Beispiel Silberoxid (Ag₂O), Antimonoxid (Sb₂O₃), Germaniumoxid (GeO₂), Indiumoxid (In₂O₃), Phosphorpentoxid (P₂O₅), Vanadiumpentoxid (V₂O₅), Niobpentoxid (Nb₂O₅) und Tantalpentoxid (Ta₂O₅). Der Anteil an Ag₂O, P₂O₅, V₂O₅, Nb₂O₅ und/oder Ta₂O₅, das in der Glasfritte enthalten sein kann, liegt jeweils im Bereich von ungefähr 0 bis 8 Gew.-%. Der Anteil an In₂O₃ und/oder Sb₂O₃ in der Glasfritte liegt vorzugsweise jeweils im Bereich von 0 bis 5 Gew.-%. Zusätzlich können in der Glasfritte ein oder mehrere Alkalioxide, üblicherweise Na₂O, Li₂O und/oder K₂O enthalten sein. Der Anteil an Alkalimetalloxiden in der Glasfritte liegt dabei jeweils im Bereich von 0 bis 3 Gew.-%. Weiterhin können auch Erdalkalimetalloxide in der Glasfritte enthalten sein. Üblicherweise enthaltene Erdalkalioxide sind BaO, CaO, MgO und/oder SrO. Der Anteil an Erdalkalioxiden in der Glasfritte liegt dabei jeweils im Bereich von 0 bis 8 Gew.-%.

Im Wesentlichen bleifrei im Sinne der vorliegenden Erfindung bedeutet, dass der Glasfritte kein Blei zugegeben wird und der Anteil an Blei in der Glasfritte kleiner als 1000 ppm ist.

Die erfindungsgemäße Zusammensetzung enthält weiterhin mindestens eine metallorganische Verbindung. Der Anteil der metallorganischen Verbindung in der Zusammensetzung liegt im Bereich von 0 bis 5 Gew.-%, bevorzugt im Bereich von 1 bis 3 Gew.-% und insbesondere im Bereich von 1,5 bis 2,5 Gew.-%.

Beim Brennen des Substrats mit der darauf aufgedruckten Zusammensetzung wird der organische Bestandteil der metallorganischen Verbindung zersetzt und aus der Zusammensetzung entfernt. Das enthaltene Metall verbleibt in der Zusammensetzung und kann zusätzlich als elektrisch leitfähiges Material dienen.

Geeignete metallorganische Verbindungen, die eingesetzt werden können, sind Metallcarboxylate, Metallpropionat, Metallalkoxide, Komplexverbindungen eines Metalls oder eine Mischung daraus. Weiterhin können die metallorganischen Verbindungen auch aromatische oder aliphatische Gruppen enthalten.

Geeignete Carboxylate sind zum Beispiel Formiate, Acetate oder Propionate. Als Alkoxide eignen sich zum Beispiel Methanolat, Ethanolat, Propanolat, Butanolat, Pentanolat, Hexanolat, Heptanolat, Octanolat, Nonanolat, Decanolat, Undecanolat und Dodecanolat.

Das Metall der metallorganischen Verbindung ist vorzugsweise ausgewählt aus der Gruppe bestehend aus Aluminium, Bismut, Zink und Vanadium.

Zusätzlich kann die metallorganische Verbindung Bor oder Silicium enthalten.

Geeignete metallorganische Verbindungen, die eingesetzt werden können, sind zum Beispiel Bismut(III)acetat, Triphenylbismut, Bismut(III)hexafluoropentandionat, Bismut(III)tetramethylheptandionat, Bismutneodecanoat, Bismut(III)-2-ethylhexanoat, Bismutcarbonatoxid, Bismutsubgallathydrat, Bismut(III)gallatbasishydrat, Bismut(III)subsalicylat, Bismut(III)tris(2,2,6,6-tetramethyl-3,5-heptandionat), Triphenylbismut(III)carbonat, Tris(2-methoxyphenyl)bismutin.

Insbesondere bevorzugte metallorganische Verbindungen sind Bismut(III)acetat, Bismut(III)2-ethylhexanoat, Bismutcarbonatoxid, Bismutsubgallathydrat, Bismut(III)gallatbasishydrat, Bismut(III)subsalicylat.

Weiterhin kann die Zusammensetzung auch weitere Additive enthalten. Additive, die in der Zusammensetzung enthalten sein können, sind zum Beispiel Dispergiermittel, Thixotropiermittel; Weichmacher, Netzmittel, Entschäumer, Trockenstoffe, Vernetzer, Komplexbildner, leitfähige Polymerpartikel und/oder Absorptionsmittel für Laserstrahlung. Die Additive können dabei jeweils einzeln oder als Mischung von zwei oder mehreren der Additive eingesetzt werden.

Der Anteil an Additiven in der Zusammensetzung liegt im Allgemeinen im Bereich von 0 bis 5 Gew.-%, bevorzugt im Bereich von 0,1 bis 3 Gew.-% und insbesondere im Bereich von 0,1 bis 2 Gew.-%.

Wenn als Additiv ein Dispergiermittel eingesetzt wird, so ist es möglich, nur ein Dispergiermittel oder mehrere Dispergiermitel zu verwenden.

Grundsätzlich sind alle dem Fachmann für die Anwendung in Dispersionen bekannten und im Stand der Technik beschriebenen Dispergiermittel geeignet. Bevorzugte Dispergiermittel sind Tenside oder Tensidgemische, beispielsweise anionische, kationische, amphotere oder nicht-ionische Tenside. Geeignete kationische und anionische Tenside sind beispielsweise in "Encyclopedia of Polymer Science and Technology", J. Wiley & Sons (1966), Band 5, Seiten 816 bis 818 und in "Emulsion Polymerisation and Emulsion Polymers", Herausgeber P. Lovell und M. EI-Asser, Verlag Wiley & Sons (1997), Seiten 224 bis 226, beschrieben. Es ist aber auch die Verwendung von dem Fachmann bekannten Polymeren mit pigmentaffinen Ankergruppen als Dispergiermittel möglich.

Wenn Thixotropiermittel als Additiv zugesetzt werden, so können zum Beispiel organische Thixotropiermittel verwendet werden. Verdicker, die eingesetzt werden können, sind zum Beispiel Polyacrylsäure, Polyurethane oder hydriertes Rizinusöl.

Weichmacher, Netzmittel, Entschäumer, Trockenstoffe, Vernetzer, Komplexbildner und leitfähige Polymerpartikel, die eingesetzt werden können, sind solche, wie sie üblicherweise in Dispersionen eingesetzt werden und dem Fachmann bekannt sind.

Wenn die Zusammensetzung durch ein Laserdruckverfahren auf das Substrat aufgedruckt werden soll, so ist es bevorzugt, wenn der Zusammensetzung als weiteres Additiv Absorptionsmittel für die Energie der Energiequelle zum Druck, zum Beispiel des Lasers, zugesetzt werden. In Abhängigkeit von der eingesetzten Laserstrahlquelle kann es notwendig sein, unterschiedliche Absorptionsmittel oder auch Gemische aus Absorptionsmitteln, die die Laserstrahlung effektiv absorbieren, zu verwenden.

Geeignete Absorptionsmittel für Laserstrahlung weisen eine hohe Absorption im Bereich der Laserwellenlänge auf. Insbesondere geeignet sind Absorptionsmittel, die eine hohe Absorption im nahen Infrarot- sowie im längerwelligen VIS-Bereich des elektromagnetischen Spektrums aufweisen. Derartige Absorptionsmittel eignen sich insbesondere zur Absorption der Strahlung von leistungsstarken Festkörperlasern, zum Beispiel Nd:YAG-Lasern sowie von IR-Diodenlasern. Geeignete Absorptionsmittel für die Laserstrahlung sind zum Beispiel im infraroten Spektralbereich stark absorbierende Farbstoffe wie Phthalocyanine, Naphthalocyanine, Cyanine, Chinone, Metall-KomplexFarbstoffe wie Dithiolene oder photochrome Farbstoffe.

Weiterhin als Absorptionsmittel geeignet sind anorganische Pigmente, insbesondere intensiv gefärbte anorganische Pigmente wie Chromoxide, Eisenoxide oder Eisenoxidhydrate.

Ebenfalls als Absorptionsmittel geeignet ist Kohlenstoff in Form von beispielsweise Ruß, Graphit, Kohlenstoffnanoröhrchen oder Graphenen.

Wenn als Absorptionsmittel Ruß eingesetzt wird, liegt der Anteil an Ruß in der Zusammensetzung im Bereich von 0 bis 5 Gew.-%. Bevorzugt liegt der Anteil im Bereich von 0,01 bis 3 Gew.-% und insbesondere im Bereich von 0,5 bis 2 Gew.-%. Als Ruß kann dabei jeder beliebige, dem Fachmann bekannte Ruß eingesetzt werden. Derartige Ruße sind dem Fachmann bekannt und im Handel erhältlich.

Neben den vorstehend genannten Absorptionsmitteln können auch Nanopartikel aus Silber, Gold, Platin, Palladium, Wolfram, Nickel, Zinn, Eisen, Indiumzinnoxid, Wolframoxid, Titancarbid oder Titannitrid als Absorptionsmittel für Laserstrahlung eingesetzt werden. Auf diese Weise ist es möglich, auf elementaren Kohlenstoff, zum Beispiel in Form von Ruß, Kohlenstoffnanoröhrchen, Graphenen oder Graphit, als Absorptionsmittel für Laserstrahlung zu verzichten oder die benötigte Menge deutlich im Vergleich zu bekannten Zusammensetzungen zu reduzieren.

Ein weiterer Vorteil der Verwendung von Silber, Gold, Platin, Palladium, Wolfram, Nickel, Zinn, Eisen, Indiumzinnoxid oder Titancarbid ist, dass diese Materialien elektrisch leitfähig sind. Aus diesem Grund wird durch den Einsatz der Nanopartikel die elektrische Leitfähigkeit der gedruckten Leiterbahnen in sehr viel geringerem Maße oder bevorzugt nicht herabgesenkt. Zudem oxidieren diese Materialien beim Brennen nicht, insbesondere ergeben sie keine gasförmigen Verbindungen, die zu einer Porosität der Leiterbahnen und dadurch zu einer Herabsetzung der Leitfähigkeit führen können. Titancarbid als Absorptionsmittel kann verbrennen, die dabei freigesetzte Menge an Kohlenstoff ist jedoch sehr viel geringer als die freigesetzte Menge bei Verwendung von elementarem Kohlenstoff als Absorptionsmittel.

In einer Ausführungsform sind die Nanopartikel sphärische Partikel. Sphärische Partikel im Rahmen der vorliegenden Erfindung bedeutet, dass die Partikel im Wesentlichen Kugelform haben, die realen Partikel jedoch auch Abweichungen von der idealen Kugelform aufweisen können. So können die realen Partikel zum Beispiel auch abgeflacht sein oder eine Tropfenform aufweisen. Auch sonstige Abweichungen von der idealen Kugelform, die herstellungsbedingt auftreten können, sind möglich.

Wenn die Nanopartikel sphärische Partikel sind, so weisen diese vorzugsweise einen Durchmesser im Bereich von 2 bis 100 nm auf. Insbesondere bei Verwendung von Infrarot-Lasern, insbesondere solchen mit einer Wellenlänge von 1050 nm hat sich gezeigt, dass sphärische Nanopartikel mit einem Partikeldurchmesser im Bereich von 2 bis 50 nm besonders geeignet sind. Besonders bevorzugt liegt der Durchmesser der sphärischen Partikel im Bereich von 6 nm.

Wenn die Nanopartikel in Form sphärischer Partikel eingesetzt werden, so liegt der Anteil der Nanopartikel in der Zusammensetzung insbesondere im Bereich von 0,5 bis 12 Gew.-%.

In einer alternativen Ausführungsform sind die Nanopartikel Prismen mit einer Kantenlänge im Bereich von 15 bis 1000 nm und einer Höhe von 3 bis 100 nm. Die Form der Prismen ist dabei variabel. So hängt die Form unter anderem auch von der eingesetzten Laserstrahlung ab. Die Grundfläche der Prismen kann so zum Beispiel in Form eines beliebigen Polygons, beispielsweise eines Dreiecks oder eines Fünfecks, ausgebildet sein. Die als Nanopartikel eingesetzten Prismen sind im Allgemeinen Plasmonresonatoren, deren Absorptionsverhalten an die Wellenlänge des eingesetzten Lasers angepasst ist. Die Anpassung an die Wellenlänge des eingesetzten Lasers erfolgt zum Beispiel durch die Kantenlänge der Prismen und durch die Querschnittsfläche. So weisen zum Beispiel unterschiedliche Querschnittsflächen und unterschiedliche Kantenlängen jeweils ein unterschiedliches Absorptionsverhalten auf. Auch übt die Höhe der Prismen einen Einfluss auf das Absorptionsverhalten aus.

Wenn Prismen als Nanopartikel eingesetzt werden, so liegt der Anteil der als Prismen vorliegenden Nanopartikel in der Zusammensetzung vorzugsweise im Bereich von 3 bis 10 Gew.-%.

Neben dem Einsatz von sphärischen Partikeln oder Prismen als Absorptionsmittel für Laserstrahlung ist es alternativ auch möglich, dass sowohl sphärische Partikel als auch Prismen eingesetzt werden. Dabei ist jedes beliebige Verhältnis an sphärischen Partikeln zu Prismen möglich. Je größer der Anteil an Nanopartikeln in Form von Prismen ist, umso niedriger kann der Anteil an Nanopartikeln in der Zusammensetzung sein.

Die Nanopartikel werden im Allgemeinen bei der Herstellung, insbesondere für den Transport, durch geeignete Additive stabilisiert. Bei der Herstellung der Zusammensetzung zum Drucken von Leiterbahnen werden die Additive üblicherweise nicht entfernt, so dass diese dann auch in der Zusammensetzung enthalten sind. Der Anteil an Additiven zur Stabilisierung liegt im Allgemeinen bei maximal 15 Gew.-% bezogen auf die Masse an Nanopartikeln. Als Additive zur Stabilisierung der Nanopartikel können zum Beispiel langkettige Amine, beispielsweise Dodecylamin eingesetzt werden. Weitere Additive, die sich zur Stabilisierung der Nanopartikel eignen, sind zum Beispiel Octylamin, Decylamin, Ölsäure und Polyethylenimine.

Ganz besonders geeignet als Absorptionsmittel für Laserstrahlung sind anorganische Pigmente, Nanopartikel aus Silber, Gold, Platin, Palladium, Wolfram, Nickel, Zinn, Eisen, Indiumzinnoxid, Wolframoxid, Titancarbid oder Titannitrid, insbesondere aus Silber, feinteilige Kohlenstoffsorten oder feinteiliges Lanthanhexaborid (LaB₆).

Die Menge des zugesetzten Absorptionsmittels wird vom Fachmann in Abhängigkeit von den gewünschten Eigenschaften der Dispersionsschicht ausgewählt. In diesem Fall wird der Fachmann zusätzlich berücksichtigen, dass das zugesetzte Absorptionsmittel nicht nur die Geschwindigkeit und Effizienz des Transfers der Zusammensetzung durch den Laser beeinflusst, sondern auch andere Eigenschaften wie die Haftung der Zusammensetzung auf dem zu bedruckenden Substrat oder die elektrische Leitfähigkeit verdruckter Leiterbahnen beeinflusst.

Die Herstellung der erfindungsgemäßen Zusammensetzung erfolgt zum Beispiel durch intensives Mischen und Dispergieren in dem Fachmann bekannten Aggregaten. Dies beinhaltet zum Beispiel das Vermischen der Komponenten in einem Dissolver oder einem vergleichbar intensiv dispergierenden Aggregat, die Dispergierung in einer Rührwerkskugelmühle oder einem Pulverfluidisator bei Herstellung großer Mengen.

Das Aufbringen der erfindungsgemäßen Zusammensetzung auf ein Substrat kann durch jedes beliebige, dem Fachmann bekannte Verfahren erfolgen. So ist zum Beispiel eine Beschichtung mit einem Druckverfahren, beispielsweise Siebdruck, Tampondruck, Tintenstrahldruck, Offsetdruck oder Laserdruck möglich. Die beim Drucken aufgebrachte Schichtdicke variiert vorzugsweise im Bereich von 0,01 bis 100 µm, weiterhin bevorzugt zwischen 0,1 und 50 µm und insbesondere bevorzugt im Bereich von 5 bis 30 µm. Die mit der erfindungsgemäßen Zusammensetzung aufgebrachten Schichten können sowohl vollflächig als auch strukturiert sein.

In einer besonders bevorzugten Ausführungsform wird die erfindungsgemäße Zusammensetzung mit einem Druckverfahren auf das Substrat aufgebracht, bei dem mittels einer energieabgebenden Einrichtung, die Energie in Form von elektromagnetischen Wellen abgibt, die Zusammensetzung eine Volumen- und/oder Positionsänderung erfährt und dadurch die Übertragung der Zusammensetzung auf das Substrat erfolgt. Derartige Verfahren sind zum Beispiel bekannt aus der WO-A 03/074278.

## Patentansprüche

1. Zusammensetzung zum Drucken von Elektroden auf einem Substrat, enthaltend 70 bis 90 Gew.-% elektrisch leitfähige Partikel mit einer mittleren Partikelgröße im Bereich von 3 nm bis 100 µm, 0 bis 7 Gew.-% Glasfritte, 0,1 bis 5 Gew.-% mindestens eines Absorptionsmittels für Laserstrahlung, 0 bis 8 Gew.% mindestens eines Matrixmaterials, 0 bis 8 Gew.-% mindestens einer metallorganischen Verbindung, 3 bis 50 Gew.-% Wasser als Lösungsmittel, 0 bis 65 Gew.-% mindestens eines Retentionsmittels und 0 bis 5 Gew.-% mindestens eines Additivs, jeweils bezogen auf die Gesamtmasse der Zusammensetzung, wobei das Retentionsmittel ein Verzögerer ist, mit dem die Verdunstung des Wassers verlangsamt wird und als Additive Dispergiermittel, Thixotropiermittel, Weichmacher, Netzmittel, Entschäumer, Trockenstoffe, Vernetzer, Komplexbildner und/oder leitfähige Polymerpartikel eingesetzt werden,
und wobei als Absorptionsmittel für Laserstrahlung anorganische Pigmente, Nanopartikel aus Silber, Gold, Platin, Palladium, Wolfram, Nickel, Zinn, Eisen, Indiumzinnoxid, Wolframoxid, Titancarbid oder Titannitrid, feinteilige Kohlenstoffsorten oder feinteiliges Lanthanhexaborid eingesetzt werden.

2. Zusammensetzung gemäß Anspruch 1, **dadurch gekennzeichnet, dass** die elektrisch leitfähigen Partikel Silber, Gold, Aluminium, Platin, Palladium, Zinn, Nickel, Cadmium, Gallium, Indium, Kupfer, Zink, Eisen, Bismuth, Cobalt, Mangan, Chrom, Vanadium, Titan oder Mischungen oder Legierungen daraus enthalten.

3. Zusammensetzung gemäß einem der Ansprüche 1 bis 2, **dadurch gekennzeichnet, dass** die elektrisch leitfähigen Partikel im Wesentlichen kugelförmig sind.

4. Zusammensetzung gemäß einem der Ansprüche 1 bis 3, **dadurch gekennzeichnet, dass** als Glasfritte ein Bismuthoxid-basiertes, bleifreies Glas verwendet wird.

5. Zusammensetzung gemäß Anspruch 4, **dadurch gekennzeichnet, dass** die Glasfritte 0,01 bis 10 Gew.-% Telluroxid enthält.

6. Zusammensetzung gemäß einem der Ansprüche 1 bis 5, **dadurch gekennzeichnet, dass** das Matrixmaterial ein wasserlösliches oder wasserdispergierbares Polymer ist.

7. Zusammensetzung gemäß einem der Ansprüche 1 bis 6, **dadurch gekennzeichnet, dass** das Retentionsmittel ausgewählt ist aus der Gruppe bestehend aus Glyzerin, Glykole, Polyglykole, Alkanolamine, n-Methylpyrrolidon, Polyethylenimine, Polyvinylamin, Polyvinylformamid oder Mischungen daraus.

8. Zusammensetzung gemäß einem der Ansprüche 1 bis 7, **dadurch gekennzeichnet, dass** die Metallorganische Verbindung ein Metallcarboxylat, ein Metallpropionat, ein Metallalkoxid, eine Komplexverbindung eines Metalls oder eine Mischung daraus ist.

9. Zusammensetzung gemäß einem der Ansprüche 1 bis 8, **dadurch gekennzeichnet, dass** das Metall der metallorganischen Verbindung ausgewählt ist aus der Gruppe bestehend aus Aluminium, Bismuth, Zink und Vanadium.

10. Zusammensetzung gemäß einem der Ansprüche 1 bis 9, **dadurch gekennzeichnet, dass** die metallorganische Verbindung zusätzlich Bor oder Silicium enthält.

11. Zusammensetzung gemäß Anspruch 1, **dadurch gekennzeichnet, dass** der feinteilige Kohlenstoff Ruß, Graphit, Kohlenstoffnanoröhrchen und/oder Graphene umfasst.

12. Verwendung der Zusammensetzung gemäß einem der Ansprüche 1 bis 11 zur Herstellung von Elektroden für Solarzellen.

## Claims

1. A composition for printing electrodes on a substrate, comprising 70 to 90% by weight of electrically conductive particles having a mean particle size in the range from 3 nm to 100 µm, 0 to 7% by weight of glass frit, 0.1 to 5% by weight of at least one absorbent for laser radiation, 0 to 8% by weight of at least one matrix material, 0 to 8% by weight of at least one organometallic compound, 3 to 50% by weight of water as a solvent, 0 to 65% by weight of at least one retention aid and 0 to 5% by weight of at least one additive, based in each case on the total mass of the composition, wherein the retention aid is a retardant which slows the evaporation of the water, and the additives used are dispersants, thixotropic agents, plasticizers, wetting agents, defoamers, desiccants, crosslinkers, complexing agents and/or conductive polymer particles,
and wherein the absorbents for laser radiation used are inorganic pigments, nanoparticles of silver, gold, platinum, palladium, tungsten, nickel, tin, iron, indium tin oxide, tungsten oxide, titanium carbide or titanium nitride, fine carbon types or fine lanthanum hexaboride.

2. The composition according to claim 1, wherein the electrically conductive particles comprise silver, gold, aluminum, platinum, palladium, tin, nickel, cadmium, gallium, indium, copper, zinc, iron, bismuth, cobalt, manganese, chromium, vanadium, titanium or mixtures or alloys thereof.

3. The composition according to any of claims 1 to 2, wherein the electrically conductive particles are essentially spherical.

4. The composition according to any of claims 1 to 3, wherein the glass frit used is a bismuth oxide-based, lead-free glass.

5. The composition according to claim 4, wherein the glass frit comprises 0.01 to 10% by weight of tellurium oxide.

6. The composition according to any of claims 1 to 5, wherein the matrix material is a water-soluble or water-dispersible polymer.

7. The composition according to any of claims 1 to 6, wherein the retention aid is selected from the group consisting of glycerol, glycols, polyglycols, alkanolamines, N-methylpyrrolidone, polyethyleneimines, polyvinylamine, polyvinylformamide or mixtures thereof.

8. The composition according to any of claims 1 to 7, wherein the organometallic compound is a metal carboxylate, a metal propionate, a metal alkoxide, a complex of a metal or a mixture thereof.

9. The composition according to any of claims 1 to 8, wherein the metal of the organometallic compound is selected from the group consisting of aluminum, bismuth, zinc and vanadium.

10. The composition according to any of claims 1 to 9, wherein the organometallic compound additionally comprises boron or silicon.

11. The composition according to claim 1, wherein the fine carbon comprises carbon black, graphite, carbon nanotubes and/or graphenes.

12. The use of the composition according to any of claims 1 to 11 for producing electrodes for solar cells.

## Revendications

1. Composition destinée à l'impression d'électrodes sur un substrat, contenant 70 à 90 % en poids de particules conductrices de l'électricité, ayant une taille moyenne de particule dans la plage de 3 nm à 100 µm, 0 à 7 % en poids de fritte de verre, 0,1 à 5 % en poids d'au moins un absorbant pour rayonnement laser, 0 à 8 % en poids d'au moins un matériau de matrice, 0 à 8 % en poids d'au moins un composé organométallique, 3 à 50 % en poids d'eau en tant que solvant, 0 à 65 % en poids d'au moins un agent de rétention et 0 à 5 % en poids d'au moins un additif, chaque fois par rapport à la masse totale de la composition, l'agent de rétention étant un ralentisseur, avec lequel l'évaporation de l'eau est ralentie et en tant qu'additifs étant utilisés des dispersants, des agents de thixotropie, des plastifiants, des agents mouillants, des antimousses, des desséchants, des agents de réticulation, des complexants et/ou des particules de polymère conductrices,
et en tant qu'absorbant pour rayonnement laser étant utilisés des pigments inorganiques, des nanoparticules d'argent, or, platine, palladium, tungstène, nickel, étain, fer, oxyde d'indium-étain, oxyde de tungstène, carbure de titane ou nitrure de titane, des variétés de carbone finement divisées ou de l'hexaborure de lanthane finement divisé.

2. Composition selon la revendication 1, **caractérisée en ce que** les particules conductrices de l'électricité contiennent de l'argent, de l'or, de l'aluminium, du platine, du palladium, de 1'étain, du nickel, du cadmium, du gallium, de l'indium, du cuivre, du zinc, du fer, du bismuth, du cobalt, du manganèse, du chrome, du vanadium, du titane ou des mélanges ou alliages de ceux-ci.

3. Composition selon l'une quelconque des revendications 1 et 2, **caractérisée en ce que** les particules conductrices de l'électricité sont essentiellement sphériques.

4. Composition selon l'une quelconque des revendications 1 à 3, **caractérisée en ce qu'**on utilise comme fritte de verre un verre sans plomb à base d'oxyde de bismuth.

5. Composition selon la revendication 4, **caractérisée en ce que** la fritte de verre contient de 0,01 à 10 % en poids d'oxyde de tellure.

6. Composition selon l'une quelconque des revendications 1 à 5, **caractérisée en ce que** le matériau de matrice est un polymère soluble dans l'eau ou dispersable dans l'eau.

7. Composition selon l'une quelconque des revendications 1 à 6, **caractérisée en ce que** l'agent de rétention est choisi dans le groupe constitué par le glycérol, les glycols, les polyglycols, les alcanolamines, la n-méthylpyrrolidone, les polyéthylène-imines, la polyvinylamine, le polyvinylformamide ou des mélanges de ceux-ci.

8. Composition selon l'une quelconque des revendications 1 à 7, **caractérisée en ce que** le composé organométallique est un carboxylate de métal, un propionate de métal, un alcoolate de métal, un composé complexe d'un métal ou un mélange de ceux-ci.

9. Composition selon l'une quelconque des revendications 1 à 8, **caractérisée en ce que** le métal du composé organométallique est choisi dans le groupe constitué par l'aluminium, le bismuth, le zinc et le vanadium.

10. Composition selon l'une quelconque des revendications 1 à 9, **caractérisée en ce que** le composé organométallique contient en outre du bore ou du silicium.

11. Composition selon la revendication 1, **caractérisée en ce que** le carbone finement divisé comprend le noir de carbone, le graphite, des nanotubes de carbone et/ou des graphènes.

12. Utilisation de la composition selon l'une quelconque des revendications 1 à 11, pour la production d'électrodes pour cellules solaires.
